# EUROPEAN PATENT APPLICATION

(11) **EP 4 525 026 A1**
(43) Date of publication of application: **19.03.2025**
(21) Application number: 24197157.1
(22) Date of filing: 29.08.2024
(51) Int. Cl.: H01L 21/48, H01L 23/15, H01L 23/498, H01L 23/538, H01L 23/13

(54) **PACKAGING SUBSTRATE AND METHOD OF MANUFACTURING PACKAGING SUBSTRATE**

(30) Priority: 30.08.2023 US 202318458159
(71) Applicant: Absolics Inc., Covington, GA 30014 (US)
(72) Inventor: KIM, Sungjin, Covington, 30014 (US); LEE, Bongyeol, Covington, 30014 (US)
(74) Representative: BCKIP Part mbB

(57) **Abstract**

The present specification relates to a method of manufacturing a packaging substrate and a packaging substrate manufactured thereby. The packaging substrate according to the present specification includes a core layer including a glass substrate having a first surface and a second surface facing each other and a cavity portion passing through the glass substrate, wherein a cavity module is disposed in the cavity portion, the cavity module comprise a cavity element and a first insulating layer is formed on some surfaces other than one surface or on all the surface of the cavity element, and a second insulating layer is incorporated into the remaining portion of the cavity portion other than the cavity module, and the first insulating layer and the second insulating layer have different dielectric constants. Accordingly, an undulation phenomenon due to a gap between elements, a gap between the cavity portion and an element, and/or the like may be prevented, and a leakage current may be prevented from occurring.

## Description

### BACKGROUND

### 1. Field of the Invention

The present disclosure relates to a packaging substrate, a semiconductor package, a method of manufacturing a packaging substrate, a method of manufacturing a semiconductor package, and the like.

### 2. Discussion of Related Art

In manufacturing electronic components, implementing a circuit on a semiconductor wafer is called as a front-end (FE) process, assembling the wafer in a state of being usable in an actual product is called as a back-end (BE) process. A packaging process is included in subsequent processes.

Four core technologies of semiconductor industry which recently enabled rapid development of electronic products include semiconductor technology, semiconductor packaging technology, manufacturing process technology, and software technology. Semiconductor technology has developed in various forms, such as nanoscale (submicron) line widths, 10 million cells or more, high-speed operation, large heat dissipation, and the like, but a relatively perfect packaging technology is not fully supported. Accordingly, the electrical performance of a semiconductor can sometimes be determined by the packaging technology and the electrical connection according to the packaging technology rather than performance of the semiconductor technology itself.

A ceramic or resin has been applied as a material of a substrate for packaging. In the case of a ceramic substrate such as a silicon substrate, it is difficult to mount a high-performance and high-frequency semiconductor element due to a high resistance value or high dielectric permittivity. In the case of a resin substrate, a relatively high-performance and high-frequency semiconductor element can be mounted. However, there is a limitation in pitch reduction of lines.

Recently, glass plate has been applied to a substrate for high-end packaging. A line length between an element and a motherboard can be shortened and electrical characteristics can become excellent by forming a through hole in a glass substrate and applying a conductive material to the through hole.

Further, a semiconductor package can generate heat while operating, and can additionally include a heat dissipation means for dissipating such heat.

Related Art Documents include US Patent Publication No. 20220293560, Korean Patent Publication No. 10-2018-0142742.

### SUMMARY OF THE INVENTION

An embodiment is directed to providing a packaging substrate manufacturing method capable of improving an undulation phenomenon which occurs due to a gap between cavity elements, a gap between a cavity portion and a cavity element, and/or the like in a packaging substrate in which a glass substrate is used, and a packaging substrate manufactured thereby.

Further, an embodiment is directed to providing a packaging substrate manufacturing method of forming a first insulating layer on some surfaces other than an upper surface or a bottom surface of a cavity element disposed in a cavity portion of a glass substrate, and forming a second insulating layer laminated on first and second surfaces of the glass substrate, and a packaging substrate manufactured thereby.

In order to achieve the above object, a packaging substrate according to one embodiment includes a core layer including a glass substrate having a first surface and a second surface facing each other and a cavity portion passing through the glass substrate, wherein a cavity module is disposed in the cavity portion, the cavity module include a cavity element and a first insulating layer which is formed on some surfaces other than one surface or on all the surface of the cavity element and a second insulating layer is incorporated into the remaining portion of the cavity portion other than the cavity module, and the first insulating layer and the second insulating layer have different dielectric constants.

The first insulating layer may have a dielectric constant lower than that of the second insulating layer.

A high-frequency dielectric constant Dk is the dielectric constant at a high frequency of 5.8 Ghz, and a difference between Dk1 as a high-frequency dielectric constant of the first insulating layer and Dk2 as a high-frequency dielectric constant of the second insulating layer may be 0.1 or more.

The dielectric loss factor of the first insulating layer is Df1, and the dielectric loss factor of the second insulating layer is Df2. A difference between the Df1 and the Df2 may be 0.0001 or more.

The first insulating layer may include liquid crystal polymer (LCP), Epoxy Molding Compound (EMC), Ajinomoto Build-up Film (ABF), or Modified Polyimide (MPI).

The second insulating layer may comprise an insulating mixture; and the insulating mixture may include inorganic particles and a polymer resin.

One or more connection electrodes may be disposed in a direction toward the surface of the cavity element.

The cavity element may comprise a passive element or an active element.

A first insulating layer via penetrating the first insulating layer may be further disposed at the first insulating layer.

Parts of or all the first insulating layer via may be filled with an electrode material.

Meanwhile, in order to achieve the above object, a method of manufacturing a packaging substrate according to one embodiment includes: preparing a glass substrate in which a cavity portion is disposed and a cavity module; arranging the cavity module in the cavity portion; and laminating a second insulating layer on the glass substrate, wherein the cavity module includes a cavity element and a first insulating layer surrounding at least a part of the cavity element, and the first insulating layer is disposed on a surface other than one surface or on all the surface of the cavity element.

The first insulating layer and the second insulating layer may have different dielectric constants.

The first insulating layer may include liquid crystal polymer (LCP), Epoxy Molding Compound (EMC), Ajinomoto Build-up Film (ABF), or Modified Polyimide (MPI).

The second insulating layer may include an Ajinomoto Build-up Film (ABF) or an epoxy molding compound (EMC).

One or more connection electrodes may be formed in a direction toward the surface of the cavity element.

### BRIEF DESCRIPTION OF THE DRAWINGS

The above and other objects, features and advantages of the present disclosure will become more apparent to those of ordinary skill in the art by describing in detail exemplary embodiments thereof with reference to the accompanying drawings, in which:
FIG. 1 is a conceptual diagram for describing a cross-sectional structure of a packaging substrate according to an embodiment;
FIG. 2 is a conceptual diagram for describing a cross-sectional structure of a packaging substrate according to another embodiment;
(a) and (b) of FIG. 3 are conceptual diagrams for describing portions of the packaging substrates according to the embodiments in cross-sections;
FIG. 4 is a flow chart for describing a process of generating a core distribution layer in a packaging substrate manufacturing process according to the embodiment in cross-sections;
FIG. 5 is a flow chart for describing a process of generating an insulating layer in the packaging substrate manufacturing process according to the embodiment in cross-sections;
FIG. 6 illustrates an example of a cross-sectional structure of a core layer of the packaging substrate generated according to the embodiment;
FIG. 7 is a flow chart for describing a packaging substrate manufacturing method according to the embodiment in cross-sections, wherein S is a formation of a first insulating layer, P1 is an arrangement of element(s), P2 is a formation of a second insulating layer (upper), P3 is a formation of a second insulating layer (lower), and P4 is cured procedure (upper/lower); and
FIG. 8 is a flow chart for describing a packaging substrate manufacturing method according to another embodiment in cross-sections, wherein P1 is an arrangement of element(s), S is a formation of a first insulating layer, P2 is a formation of a second insulating layer (upper), P3 is a formation of a second insulating layer (lower), and P4 is cured procedure (upper/lower).

### DETAILED DESCRIPTION OF EXEMPLARY EMBODIMENTS

In order to help comprehensive understanding of methods, devices and/or systems described in the present specification, the following detailed description is provided. However, various changes, modifications and equivalents of the methods, devices and/or systems described in the present specification will become apparent after understanding the contents written in the present specification. For example, an order of operations described in the present specification is merely exemplary, and is not limited to the operations disclosed in the present specification. The order of operations except for operations necessarily performed in a predetermined order may be changed according to the understanding of the contents written in the present application. Further, descriptions of already known features may be omitted to increase clarity and conciseness after understanding the disclosed contents of the present application. However, omitting the features and the descriptions is not intended to be recognized as general knowledge.

Features described in the present specification may be realized in different forms, and are not interpreted as being limited to examples described in the present specification. On the contrary, the embodiments described in the present specification are provided to describe some of the many possible methods, and implementation methods of devices and/or systems described in the present specification which will become apparent after understanding the present application.

In the present specification, terms "first," "second," "third," and the like may be used to describe various members, components, regions, layers or cross-sections, but the members, components, regions, layers, or cross-sections, are not limited by these terms. Alternatively, these terms are used to distinguish one member, component, region, layer, or section from another member, component, region, layer, or section. Accordingly, a first member, component, region, layer, or section mentioned in the embodiments described in the present specification may also be referred to as a second member, component, region, layer, or section without departing from teachings of the embodiments.

Throughout the specification, a case in which a component such as a layer, region, or substrate is described as "on," "connected to," or "coupled to" another component, may be described as directly "on," "connected to," or "coupled to" another component, or may be described as "on," "connected to," or "coupled to" another component with one or more other component interposed therebetween. On the contrary, when any component is described as "directly on," "directly connected to," or "directly coupled to," other components may not be interposed. Likewise, for example, terms such as "between" and "directly between," and "in contact with each other" and "directly in contact with each other" may be interpreted as described above.

Terms used the present specification are only for describing specific examples, and are not used to limit the disclosure. A singular form used in the present specification is intended to also include a plural form, unless the context clearly indicates otherwise. A term "and/or" includes any one or combination of two or more of related listed items. Terms "includes," "constitutes," and "has" indicate the presence of specified features, numbers, operations, elements, components, and/or combinations thereof, but do not preclude the presence or addition of one or more other features, numbers, operations, elements, and/or combinations thereof. Use of the term "may" in the present specification in relation to an example or embodiment (for example, for what the example or embodiment may include or implement) refers to at least one example or embodiment in which this feature is included or realized is present, but not all examples are limited thereto.

In the present application, a case in which "B is located on A" refers to a case in which B comes into direct contact with A or a case in which B is disposed on A with another layer or structure interposed therebetween, and accordingly, the case in which B is disposed on A with another layer or structure interposed therebetween should not be interpreted as a case in which B comes into direct contact with A.

Unless otherwise defined, all terms used in the present specification have the same meaning as generally understood by those skilled in the art. Terms such as terms defined in generally used dictionaries should be interpreted as having meanings consistent with the meanings in the context of the related art and the present disclosure, and should not be idealized or interpreted as excessively formal meanings unless otherwise explicitly defined.

In the one or more examples, descriptions for "A and/or B" refer to "A, B or A and B."

In the one or more examples, the term "first," "second," "A," or "B" is used to distinguish the same terms from each other.

In the one or more examples, a singular form is contextually interpreted as including a plural form as well as the singular form unless otherwise specifically mentioned.

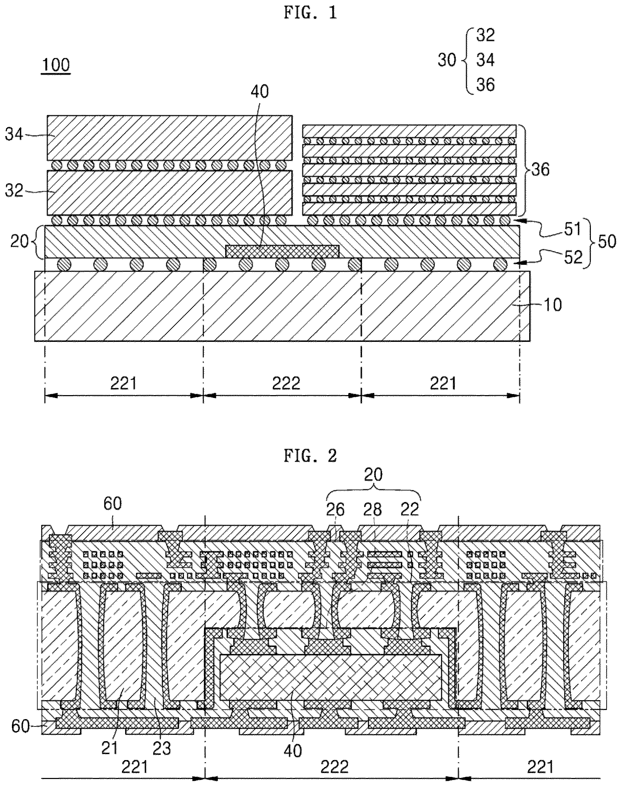

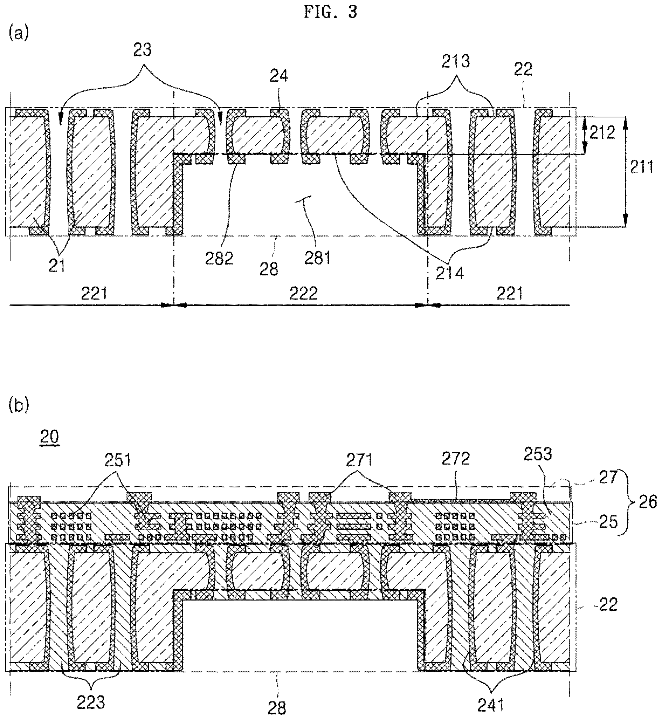

FIG. 1 is a conceptual diagram for describing a cross-sectional structure of a packaging substrate according to an embodiment, FIG. 2 shows a conceptual diagram for describing a cross-sectional structure of a packaging substrate according to another embodiment, and (a) and (b) of FIG. 3 are conceptual diagrams for describing portions of the packaging substrates according to the embodiments in cross-sections.

In order to achieve the above object, a semiconductor device 100 according to the embodiment comprises a semiconductor element portion 30 in which one or more semiconductor elements 32, 34, and 36 are located, a packaging substrate 20 electrically connected to the semiconductor elements, and a motherboard 10 that is electrically connected to the packaging substrate 20, transmits an external electrical signal to the semiconductor elements 32, 34, and 36, and connects the semiconductor elements 32, 34, and 36 to each other.

A packaging substrate 20 according to the embodiment comprises a core layer 22, an upper layer 26 located on one surface of the core layer 22, and a cavity portion 28 in which a cavity element 40 may be located.

The semiconductor element portion 30 refers to elements mounted in the semiconductor device, and is mounted on the packaging substrate 20 by a connection electrode or the like. Specifically, as the semiconductor element portion 30, for example, arithmetic elements (a first element 32, a second element 34) such as a central processing unit (CPU), a graphics processing unit (GPU), and the like, a storage element (a third element 36) such as a memory chip, and the like may be applied, but any semiconductor element mounted in a semiconductor device may be applied without limitation.

A motherboard such as a printed circuit board, a printed wiring board, or the like may be applied as the motherboard 10.

The packaging substrate 20 may selectively further comprise a lower layer (not shown) located under the core layer.

The core layer 22 may comprise a glass substrate 21 comprising first regions 221 each having a first thickness 211 and a second region 222 adjacent to the first regions 221 and having a second thickness 212 thinner than the first thickness, a plurality of core vias 23 passing through the glass substrate 21 in a thickness direction, and a core distribution layer 24 that is located on a surface of the glass substrate 21 or the core via 23 and electrically connects a first surface 213 of the glass substrate 21 and a second surface 214 facing the first surface through the core vias 23.

The second region 222 of the core layer 22 may serve as a cavity structure.

In the same region, the glass substrate 21 has the first surface 213 and the second surface 214 facing each other, and these two surfaces are generally parallel to each other and have uniform thicknesses throughout the glass substrate 21.

An inner space 281 formed by a thickness difference between the first region 221 and the second region 222 serves to accommodate part or all of the cavity element 40.

The glass substrate 21 may comprise the core vias 23 passing through the first surface 213 and the second surface 214. The core vias 23 may be formed in both the first region 221 and the second region 222, and may be formed with an intended pitch and pattern.

Conventionally, a form in which a silicon substrate and an organic substrate are stacked was applied as a packaging substrate for a semiconductor device. In the case of silicon substrates, there is a concern that parasitic elements are generated when applied to a high-speed circuit due to the nature of semiconductors, and a disadvantage in that power loss is relatively large. Further, in the case of organic substrates, a large area is required to form a more complicated distribution pattern, but this does not conform to the trend of manufacturing miniaturized electronic devices. In order to form a complicated distribution pattern within a predetermined size, pattern miniaturization is substantially required, but there is a practical limit to pattern miniaturization due to the nature of materials such as a polymer and the like applied to organic substrates.

In the embodiment, as a method of solving such problems, the glass substrate 21 is applied as a support of the core layer 22. Further, the packaging substrate 20 having a relatively shortened electrical flow, a relatively compact size, a faster response, and less loss characteristics is provided by applying the core vias 23 formed to pass through the glass substrate 21 along with the glass substrate 21.

As the glass substrate 21, a glass substrate applied to a semiconductor may be applied, and for example, a borosilicate glass substrate, an alkali-free glass substrate, or the like may be applied, but the present disclosure is not limited thereto.

The core vias 23 pass through the glass substrate 21. The core vias 23 may be formed in a method of removing predetermined regions of the glass substrate 21, and may be formed by physically and/or chemically etching plate-shaped glass.

Specifically, the formation of the core vias 23 may be performed by chemically etching or laser etching, or the like after forming defects (flaws) on the surface of the glass substrate using a method such as a laser, but the present disclosure is not limited thereto.

The number of core vias 23 located in the glass substrate 21 based on a unit area (1 cm x 1 cm) may be 100 to 3,000, 100 to 2,500, or 225 to 1,024. When this pitch condition is satisfied, the formation of an electrically conductive layer and the like and the performance of the packaging substrate may be improved.

The core distribution layer 24 comprises a core distribution pattern 241, which is an electrically conductive layer electrically connecting the first surface and the second surface of the glass substrate through through-vias, and a core insulating layer 223, which covers the core distribution pattern 241. The core layer 22 may be formed with the electrically conductive layer therein through the core vias to serve as an electrical path crossing the glass substrate 21, and may connect upper and lower portions of the glass substrate with a relatively short distance to have characteristics of faster electrical signal transmission and low loss. For example, a copper-plated layer may be applied as the electrically conductive layers, but the present disclosure is not limited thereto.

The shape of the cavity portion 28 is substantially not limited to a shape such as a circular shape, a triangular shape, a quadrangular shape, a hexagonal shape, an octagonal shape, a cross shape, and the like.

The shape of the cavity element 40 may generally be a cylindrical shape, rectangular parallelepiped shape, or a polygonal pillar shape.

The cavity portion 28 may comprise a cavity distribution pattern, which is an electrically conductive layer electrically connecting the cavity element 40 and the core distribution layer 24, and an insulating layer, which covers the cavity distribution pattern.

Meanwhile, a cavity portion according to another embodiment may be implemented in the form of passing through the first surface 213 and the second surface 214 of the glass substrate 21. In this case, the cavity portion may be formed according to a similar process as a process of forming the core via 23, and the area and shape passing through the glass substrate 21 may be different from those of the core via 23.

In this embodiment, after the cavity element 40 is arranged in the cavity portion, an insulating layer may be formed. That is, the insulating layer may also be generated in the cavity portion through a process of generating the above-described core insulating layer 223.

The core distribution pattern 241 may be formed to be electrically connected to the cavity element 40.

The cavity element 40 may comprise an active element such as a transistor or a power transmission element such as a multilayer ceramic capacitor (MLCC), that is, a passive element.

When an element such as a transistor serving to convert an electrical signal between a motherboard and a semiconductor element portion to an appropriate level is applied as the cavity element 40, since a transistor or the like is applied to the path of the packaging substrate 20, a more efficient and faster semiconductor device 100 may be provided.

Further, a power transmission element such as a multilayer ceramic capacitor (MLCC) plays an important role in the performance of a semiconductor element. Generally, at least 200 or more power transmission elements, which are passive elements, are applied to a semiconductor element, and performance thereof is also affected by the characteristics of an electrically conductive layer around the element in power transmission. In one embodiment, a core via having a non-circular shape rather than a circular shape may be applied to a place, where a low-resistance electrically conductive layer is required, such as a power transmission element.

Meanwhile, a passive element, such as a capacitor or the like, may be individually inserted into and applied to the cavity element 40, and an element group including a plurality of passive elements in the form of being embedded between insulator layers (cavity element insulating layers) may be formed such that electrodes are exposed, and then inserted into the cavity element. In the latter case, the workability of manufacturing the packaging substrate may become smoother, and there is a relative advantage in that the insulating layer is sufficiently and reliably located in a space between complicated elements.

The glass substrate 21 serves as an intermediate and intermediary, which connect the semiconductor element portion 30 and the motherboard 10 at an upper portion and a lower portion, respectively, and the core vias 23 serve as paths through which the electrical signals thereof are transmitted, and thus smoothly transmit the signals.

The upper layer 26 is located on the first surface 213.

The upper layer 26 may comprise an upper distribution layer 25 and an upper surface connection layer 27 located on the upper distribution layer 25, and the uppermost surface of the upper layer 26 may be protected by a cover layer 60 formed with an opening that may come into direct contact with the connection electrode of the semiconductor element portion.

The upper distribution layer 25 may comprise an upper insulating layer 253 located on the first surface, and an upper distribution pattern 251 embedded in the upper insulating layer 253 as an electrically conductive layer having a predetermined pattern and to which the core distribution layer 24 is at least partially connected.

Any one which is applied as an insulator layer in a semiconductor element or a packaging substrate may be applied as the upper insulating layer 253, for example, an epoxy-based resin or the like including a filler may be applied, but the present disclosure is not limited thereto.

The insulator layer may be formed by a method of forming and curing a coating layer, and may also be formed by a method of laminating an insulator film formed to be a film in an uncured or semi-cured state on the core layer 22 and curing the insulator film. In this case, when a pressure sensitive lamination method or the like is applied, since insulator is incorporated into a space in the core via 23, and thus an efficient process may be performed.

According to one embodiment, even when multi-layer insulator layers are stacked and applied, it may become difficult to substantially distinguish the insulator layers, and a plurality of insulator layers are collectively called an upper insulation layer. Further, the same insulating material may be applied to the core insulating layer 223 and the upper insulating layer 253, and in this case, a boundary thereof may not be substantially distinguished. Alternatively, according to another embodiment, a boundary of the insulator layers may be generated by setting the pressure and temperature for curing the multi-layer insulator layers differently.

The upper distribution pattern 251 refers to an electrically conductive layer located in the upper insulating layer 253 in a preset form, and may be formed, for example, using a build-up layer method. Specifically, the upper distribution pattern 251 formed with an electrically conductive layer in a vertical direction or horizontal direction in an intended pattern may be formed by repeating a method of forming an insulator layer, removing unnecessary portions of the insulator layer, and then forming an electrically conductive layer by a method of copper plating or the like, selectively removing unnecessary portions of the electrically conductive layer, and then forming an insulator layer again on the electrically conductive layer, and removing unnecessary portions, and then forming an electrically conductive layer by a method of plating or the like.

The upper distribution pattern 251 is located between the core layer 22 and the semiconductor element portion 30, and thus is formed to comprise a micro pattern in at least a portion thereof so that transmission of the electrical signals with the semiconductor element portion 30 may be smoothly performed and an intended complicated pattern may be sufficiently accommodated. In this case, each of a width and an interval of the micro pattern may be smaller than 4 µm, 3.5 µm or less, 3 µm or less, and 2.5 µm or less, or 1 to 2.3 µm (hereinafter, descriptions for the micro pattern are the same).

At least a portion of the upper surface connection layer 27 is electrically connected to the upper distribution pattern 251, and the upper surface connection layer 27 comprises an upper surface connection pattern 272 located on the upper insulating layer 253 and an upper surface connection electrode 271, which electrically connects the semiconductor element portion 30 and the upper surface connection pattern 272.

The upper surface connection pattern 272 may be located on one surface of the upper insulating layer 253, and may be embedded in the upper insulating layer while at least a portion of the upper surface connection pattern 272 may be exposed on the upper insulating layer. For example, when the upper surface connection pattern is located on one surface of the upper insulating layer, the upper insulating layer may be formed by a method of plating or the like, and a case in which the upper surface connection pattern is embedded in the upper insulating layer while the portion of the upper surface connection pattern is exposed on the upper insulating layer, may be a case in which a portion of the insulating layer or electrically conductive layer is removed by a method such as surface polishing, surface etching, or the like after a copper-plated layer or the like is formed.

At least a portion of the upper surface connection pattern 272 may comprise a fine pattern like the above-described upper distribution pattern 251. The upper surface connection pattern 272 comprising the fine pattern allows a relatively larger number of elements to be connected even in a small area to make an electrical signal connection between the elements or with the outside smooth, and more integrated packaging is possible.

The upper surface connection electrode 271 may be directly connected to the semiconductor element portion 30 through a terminal or the like, and may also be connected to the semiconductor element portion 30 through an element connection portion 51 such as a solder ball.

The cavity portion 28 is located on and/or under the second region 222 and may comprise a cavity distribution layer 282 electrically connected to the core distribution pattern 241 and the inner space 281 in which the cavity element 40 is located.

Specifically, the thickness of the glass substrate 21 in the second region 222 is thinner than a thickness of the glass substrate 21 in the first region 221, and the cavity element 40 may be located in the inner space 281 formed due to the thickness difference. Further, the core vias 23 and the core distribution layer 24 formed in the glass substrate 21 serve as an electrical connection structure connecting the cavity element 40 and external elements.

Further, as described above, in the second region 222 other than the first region 221, that is, a cavity portion in the form of passing through the first surface 213 and the second surface 214 of the glass substrate 21 may be generated, and the cavity element 40 may be arranged in the cavity portion.

The packaging substrate 20 is also connected to the motherboard 10. A terminal of the motherboard 10 may be directly connected to the core distribution pattern 241 located on at least a portion of the second surface 214 of the core layer 22, and the motherboard 10 may be electrically connected to the core distribution pattern 241 through a board connection portion 52 such as a solder ball. Further, the core distribution pattern 241, which comes into contact with the motherboard 10, may be connected to the motherboard 10 through a lower layer (not shown) located under the core layer 22.

According to an example, other additional substrates other than the glass substrate 21 may not be substantially applied to the packaging substrate 20 located between the semiconductor element portion 30 and the motherboard 10.

Conventionally, an interposer and an organic substrate were stacked together and applied between the element and the motherboard while connecting the element and the motherboard because a multi-stage form is applied for at least two reasons: : one is that there is a scale problem in directly bonding a micro pattern of the element to the motherboard; and the other is that a problem of wiring damage due to a difference in thermal expansion coefficient may occur during a bonding process or a process of driving the semiconductor device . In the embodiment, this problem was solved by applying a glass substrate having a thermal expansion coefficient similar to that of a semiconductor element, and forming a micro pattern having a sufficiently fine scale for mounting the element on the first surface and an upper layer of the glass substrate.

Hereinafter, a packaging substrate manufacturing method according to the embodiment of the present disclosure will be described.

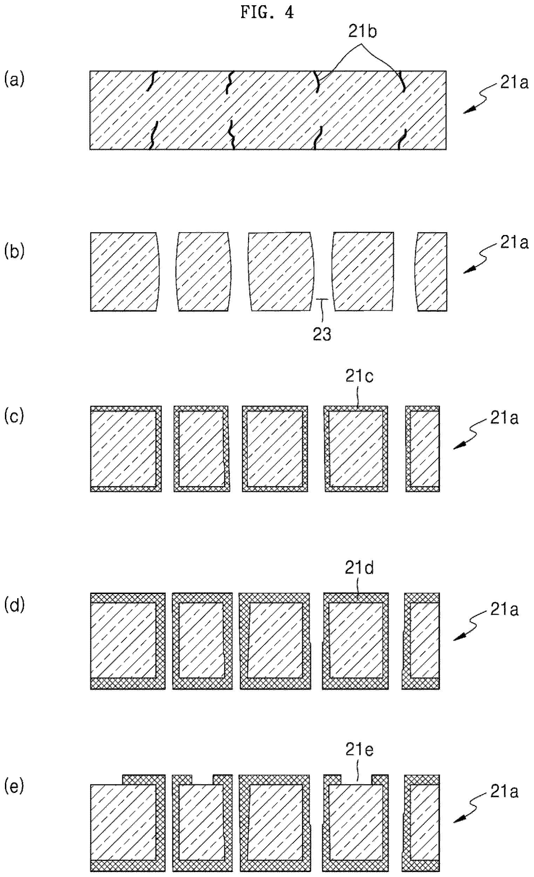

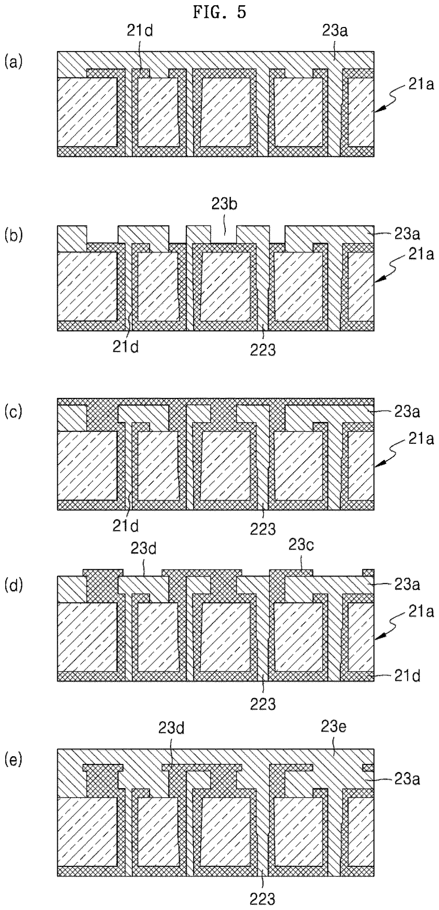

FIGS. 4 and 5 are flow charts for describing the packaging substrate manufacturing process according to the embodiment in cross-sections.

First, as shown in FIG. 4 (a), a glass substrate 21a having flat first and second surfaces is prepared, and defects (grooves) 21b are formed at predetermined positions in a glass surface to form core vias. A glass substrate applied to a substrate of an electronic device or the like may be applied as the glass substrate, for example, an alkali-free glass substrate may be applied as the glass substrate, but the present disclosure is not limited thereto. As commercially available products, products manufactured by manufacturers such as Corning, Schott, AGC, and the like may be applied. A method such as mechanical etching, laser irradiation, or the like may be applied to the formation of the defects (grooves).

As shown in FIG. 4 (b), in the glass substrate 21a having the defects (grooves) 21b, an etching operation of forming the core vias 23 through a physical or chemical etching process is performed. During the etching process, the vias are formed in defective portions of the glass substrate, and the surface of the glass substrate 21a may also be etched. In order to prevent etching of the glass surface, a masking film or the like may be applied, but considering the inconvenience of applying and removing the masking film, the defective glass substrate itself may be etched, and in this case, the thickness of the glass substrate having the core vias may be somewhat thinner than the initial thickness of the glass substrate.

Thereafter, as shown in FIG. 4 (c) and (d), a core layer manufacturing operation may be performed by forming an electrically conductive layer 21d on the glass substrate. A metal layer comprising copper metal may be representatively applied as the electrically conductive layer, but the present disclosure is not limited thereto.

Since the surface of the glass (comprising the surface of the glass substrate and a surface of the core via) and the surface of the copper metal have different properties, adhesion may be low. In the embodiment, the adhesion between the glass surface and the metal may be improved by two methods such as a dry method and a wet method.

The dry method is a method of applying sputtering, that is, a method of forming a seed layer 21c on the glass surface and an inner diameter of the core via through metal sputtering. Dissimilar metals such as titanium, chromium, and nickel may be sputtered together with copper to form the seed layer, and in this case, glass-metal adhesion may be improved by an anchor effect, in which metal particles interact with the surface morphology of the glass, or the like.

The wet method is a method of performing primer treatment, and is a method of forming a primer layer 21c by performing pre-treatment with a compound having a functional group such as an amine. The primer treatment may be performed with a compound or particles having an amine functional group after performing pre-treatment with a silane coupling agent according to the degree of intended adhesion. As mentioned above, a support substrate of the embodiment needs to have high enough performance to form a micro pattern, and this should be maintained even after primer treatment. Accordingly, when such a primer includes nanoparticles, nanoparticles having an average diameter of 150 nm or less may be applied, for example, nanoparticles having an amine group may be applied. The primer layer may be, for example, formed by applying a bonding strength improving agent, e.g., the CZ series manufactured by MEC or the like.

In the seed layer/primer layer 21c, the electrically conductive layer may selectively form the metal layer in a state in which unnecessary portions for the formation of the electrically conductive layer are removed or not removed. Further, in the seed layer/primer layer 21c, portions required or not required for the formation of the electrically conductive layer in an activated or deactivated state may be treated selectively with metal plating to perform subsequent processes. For example, light irradiation treatment such as a laser of a certain wavelength or the like, chemical treatment, or the like may be applied to the activation or deactivation treatment. A copper plating method or the like applied to semiconductor element manufacturing may be applied to the formation of the metal layer, but the present disclosure is not limited thereto.

As shown in FIG. 4 (e), a portion of the core distribution layer may be removed when unnecessary, and after a portion of the seed layer is removed or deactivated, metal plating may be performed to form an electrically conductive layer in a predetermined pattern, and then an etching layer 21e of the core distribution layer is formed.

FIG. 5 describes a manufacturing operation of forming an insulating layer and an upper distribution pattern according to one embodiment.

As shown in FIG. 5 (a), the core via may go through an insulating layer forming operation of filling an empty space with an insulating layer after forming a core distribution layer, which is the electrically conductive layer. In this case, an insulating layer manufactured in the form of a film may be applied as the insulating layer to be applied, and for example, a pressure sensitive lamination method of the insulating layer in the form of a film, or the like may be applied. When the pressure sensitive lamination is performed in this way, the insulating layer is sufficiently incorporated into the empty space in the core via to form a core insulating layer in which a void is not formed.

FIG. 5 (b) to (e) describe an upper layer manufacturing operation.

The upper layer manufacturing operation is an operation of forming an upper distribution layer comprising an upper insulating layer and an upper distribution pattern on the core layer. The upper insulating layer may be formed by a method of coating a resin composition forming an insulating layer 23a or laminating insulating films, and for convenience, the method of laminating the insulating films is better. The laminating of the insulating films may be performed by a process of laminating and curing the insulating films, and in this case, when a pressure sensitive lamination method is applied, an insulating resin may be sufficiently incorporated even into a layer in which the electrically conductive layer is not formed in the core via or the like. An upper insulating layer which comes into direct contact with at least a portion of the glass substrate, and thus has sufficient adhesion is applied as the upper insulating layer. Specifically, the glass substrate and the upper insulating layer may have characteristics in which adhesion test values according to ASTM D3359 satisfy 4B or more.

The upper distribution pattern may be formed by repeating the process of forming an insulating layer 23a, and forming an electrically conductive layer 23c in a predetermined pattern and etching unnecessary portions to form an etching layer 23d of the electrically conductive layer, and electrically conductive layers formed adjacent to each other with the insulating layer therebetween may be formed by a method of performing a plating process after forming a blind via 23b in the insulating layer. A dry etching method such as laser etching, plasma etching, or the like, a wet etching method using a masking layer and an etchant, or the like may be applied to the formation of the blind via.

Hereinafter, although not shown in the drawings, an upper surface connection layer and a cover layer may be formed.

The upper surface connection pattern and the upper surface connection electrode may also be formed in a process similar to forming the upper distribution layer. Specifically, the upper surface connection pattern and the upper surface connection electrode may be formed by a method of forming an etching layer of the insulating layer on an insulating layer 23e, forming an electrically conductive layer thereon, and then forming an etching layer of the electrically conductive layer, or the like, but a method of selectively forming only the electrically conductive layer without applying an etching method may also be applied. The cover layer may be formed so that an opening (not shown) may be formed at a position corresponding to the upper surface connection electrode and thus the upper surface connection electrode is exposed, and the cover layer may be directly connected to an element connection portion, a terminal of an element, or the like.

When the upper layer is generated, a process for the lower layer may be performed by forming a lower connection layer and the cover layer. A lower distribution layer and/or the lower connection layer, and selectively, the cover layer (not shown) may be formed in a manner similar to the above-described operation of forming the upper surface connection layer and cover layer.

As described above, the cavity element may be formed in the insulating layer by laminating an insulating film (for example, Ajinomoto Build-up Film, ABF), and in this case, an undulation phenomenon may occur. Specifically, in the cavity portion in which the element is embedded, the undulation phenomenon may become severe due to a gap between the elements and/or a gap between the cavity portion and the element. When the undulation phenomenon becomes severe, a leakage current may occur in the cavity portion, and may be fatal to active elements or the like vulnerable to leakage current.

Accordingly, the present specification proposes an embodiment that achieves objectives such as improving a leakage current prevention effect, reducing defects in a packaging substrate, and the like by preventing the occurrence of the undulation phenomenon in the cavity portion in which the element is embedded. For example, according to one embodiment of the present specification, performing a process of forming the insulating film multiple times instead of once is proposed.

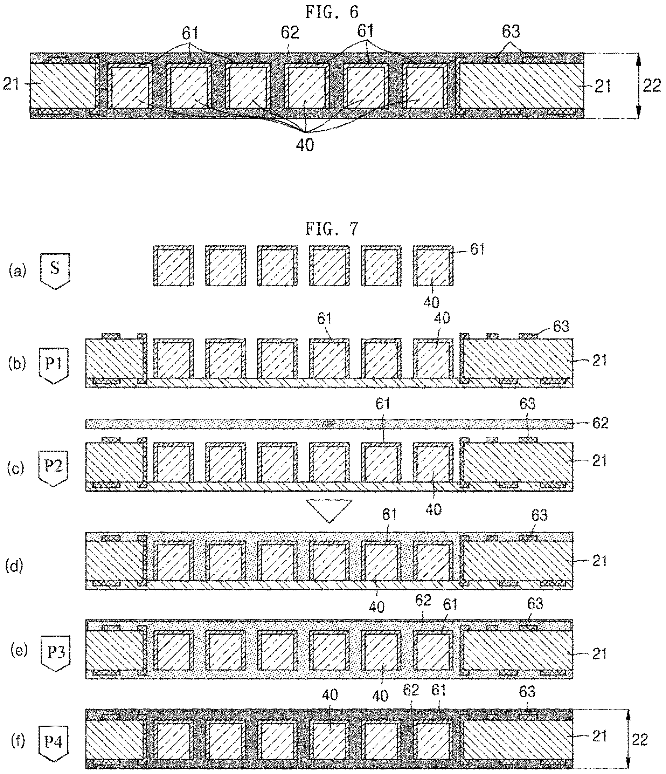

FIG. 6 illustrates an example of a cross-sectional structure of a core layer of a packaging substrate generated according to the embodiment. The packaging substrate in FIG. 6 is a conceptually simplified view for describing the core layer generated according to the embodiment, and contents described with reference to FIGS. 1 to 3 may be applied.

For example, a core layer 22 comprising a glass substrate 21 having first and second surfaces facing each other and a core via passing through the glass substrate 21 may be formed. Electrodes 63 may be formed on the surface of the glass substrate 21.

Further, for example, the cavity portion 28 according to FIG. 6 is formed to pass through both the first and second surfaces of the glass substrate 21, and the cavity element 40 is disposed in the cavity portion 28. As described above, the cavity element 40 may comprise both passive elements and active elements.

The cavity portion 28 may be formed simultaneously with the core via through the same forming operation as the core via, and may also be formed independently after or before the core via is formed.

Further, some surfaces other than one surface or all the surface of the cavity element 40 disposed in the cavity portion 28 according to FIG. 6 may be covered by a first insulating layer 61. That is, for example, in the cavity portion according to FIG. 6, the cavity element 40 is disposed, and the first insulating layer may be formed on some surfaces other than one surface or all the surface of the cavity element 40. The cavity element 40 and the first insulating layer 61 covering the cavity element 40 are referred to as a cavity module.

For example, when the cavity element 40 has a hexahedral shape, five surfaces other than one surface (ex. a bottom surface) may be covered by the first insulating layer 61. Alternatively, edges of the upper surface of the cavity element 40 may be covered by the first insulating layer 61. That is, the first insulating layer 61 may be formed on the edges of the upper surface of the cavity element 40.

For example, when the cavity element 40 has a cylindrical shape, side surfaces and/or an upper surface other than the bottom surface of the cavity element 40 may be covered by the first insulating layer 61. Alternatively, an edge of the upper surface of the cavity element 40 may be covered by the first insulating layer 61. That is, the first insulating layer 61 may be formed on the edge of the upper surface of the cavity element 40.

For example, one or more connection electrodes may be formed in a direction toward the bottom surface of the cavity element 40. Alternatively, for example, five surfaces other than the upper surface of the cavity element 40 may be covered by the first insulating layer 61. Alternatively, for example, edges of the bottom surface of the cavity element 40 may be covered by the first insulating layer 61. That is, the first insulating layer 61 may be formed on the edges of the bottom surface of the cavity element 40. In this case, for example, one or more connection electrodes may be formed in a direction toward the upper surface of the cavity element 40.

The first insulating layer 61 may be formed on some surfaces other than one surface or all the surface of the cavity element 40 to prevent a short circuit due to contact between the cavity elements which are disposed side by side. Further, a short circuit, which may unintentionally occur during a manufacturing process of forming an electrically conductive layer on a side surface of the cavity portion 28, may be prevented using the first insulating layer 61 formed on some surfaces other than one surface or all the surface of the cavity element 40.

Further, the core layer 22 according to FIG. 6 may comprise a second insulating layer 62 laminated on the first surface and the second surface. The remaining portion of the cavity portion 28 other than the cavity element 40 and the first insulating layer 61 shown in FIG. 6 may be filled with the second insulating layer 62.

That is, the cavity module is disposed in the cavity portion 28 and a residue space might be occurred in which a second insulating layer 62 will be filled. For example, the core layer 22 shown in FIG. 6 may comprise the second insulating layer 62 incorporated into the remaining portion of the cavity portion 28 other than the cavity module. For example, the second insulating layer 62 may be laminated on an upper portion (for example, the first surface) and a lower portion (for example, second surface) of the glass substrate 21 and cured, and accordingly, the second insulating layer may be generated.

A connection electrode may be disposed to be connected to the cavity element 40.

A connection electrode may be disposed on an exposed surface of the cavity element 40 on which the first insulating layer 61 is not disposed.

A connection electrode may be disposed while passing through the first insulating layer 61 of the cavity element 40. The connection electrode may be in the form of a blind via.

A first insulating layer via (not shown) penetrating the first insulating layer may be further disposed on the first insulating layer. The first insulating layer via may be partially or entirely filled with an electrode material.

The first insulating layer via may be in contact with the cavity element 40, and the other end of the first insulating layer via may be exposed to the outside of the cavity portion 28.

The first insulating layer via may be disposed to penetrate the cavity portion 28 vertically without directly contacting the cavity element 40.

An electrically conductive material can be applied to the electrode material, and for example, an electrically conductive metal can be applied. Specifically, copper, a copper alloy, silver, or the like may be applied, but is not limited thereto.

Here, the same material may be applied as the first insulating layer 61 and the second insulating layer 62, or different materials may also be applied as the first insulating layer 61 and the second insulating layer 62. In the latter case, materials having different dielectric constants may be applied.

For example, the first insulating layer 61 and the second insulating layer 62 may have different dielectric constants. For example, the first insulating layer 61 may have a dielectric constant lower than or equal to that of the second insulating layer 62. In this case, there is an advantage in that a sufficient insulation effect may be expected for each cavity element while substantially suppressing the occurrence of the undulation phenomenon in the cavity portion.

The first insulating layer 61 and the second insulating layer 62 may comprising insulating materials respectively.

For example, a polymer resin, a mixed material of a polymer resin and a filler (inorganic particles, organic particles, organic-inorganic composite particles, or the like), an inorganic deposition layer, or the like may be applied as the insulating material.

For example, an acrylic resin, an epoxy resin, a modified resin thereof, or the like may be applied as the polymer resin, and a material applicable to an electronic device for molding or the like may also be applied as the polymer resin. For example, a liquid crystal polymer (LCP) or the like may be applied.

For example, a mixture of an acrylic resin and a filler, a mixture of an acrylic resin and an epoxy resin and a filler, a mixture of an epoxy resin and a filler, or the like may be applied as the mixed material. Inorganic particles may be applied as the filler, for example, silica particles may be applied. The Ajinomoto Build-up Film (APF), an epoxy molding compound (EMC), Modified Polyimide (MPI) or the like may be applied as a commercial product, but is not limited thereto.

For example, a silicon oxide deposition layer, a silicon nitride deposition layer, or the like may be applied as the inorganic deposition layer, but is not limited thereto.

Materials having the same or different coefficients of thermal expansion (CTE) may be applied as the first insulating layer 61 and the second insulating layer 62. Preferably, materials having a small difference between the coefficient of thermal expansion of the first insulating layer 61 and the coefficient of thermal expansion of the second insulating layer 62 may be applied.

The difference between the coefficients of thermal expansion of the material of the first insulating layer and the material of the second insulating layer may be 2 ppm/°C or less, 1.5 ppm/°C or less, 1 ppm/°C or less, or 0.5 ppm/°C or less. The difference between the coefficients may be 0 ppm/°C or more, 0.1 ppm/°C or more, or 0.2 ppm/°C or more.

The coefficient of thermal expansion of the first insulating layer 61 may be 8 ppm/°C or more, 10 ppm/°C or more, 12 ppm/°C or more, or 14 ppm/°C or more. The coefficient of thermal expansion may be 20 ppm/°C or less, 18 ppm/°C or less, or 17 ppm/°C or less.

The coefficient of thermal expansion of the second insulating layer 62 may be 8 ppm/°C or more, 10 ppm/°C or more, or 12 ppm/°C or more. The coefficient of thermal expansion may be 20 ppm/°C or less, 18 ppm/°C or less, 17 ppm/°C or less, 16 ppm/°C or less, or 14 ppm/°C or less.

Materials having different dielectric constants may be applied as the first insulating layer 61 and the second insulating layer 62. Preferably, the materials of the insulating layers may be selected and applied so that the dielectric constant of the first insulating layer 61 is lower than the dielectric constant of the second insulating layer 62.

Materials having different relative permittivity Dk at high frequency of 5.8Ghz may be applied as the first insulating layer 61 and the second insulating layer 62. Preferably, a difference between the Dk of the first insulating layer 61 and the Dk of the second insulating layer 62 may be 0.1 or mare. The difference of the above Dks may be 0.1 or more, 0.13 or more, 0.16 or more, or 0.2 or more. The difference of the above Dks may be 1 or less, 0.8 or less, 0.6 or less, 0.5 or less, 0.4 or less, 0.3 or less, or 0.25 or less.

A Dk of the first insulating layer 61 may be 2.3 or more, 2.5 or more, 2.7 or more, or 2.9 or more. The Dk of the first insulating layer 61 may be 3.4 or less, 3.2 or less, or 3.1 or less.

A Dk of the second insulating layer 62 may be 3 or more, 3.1 or more, or 3.2 or more. The Dk of the second insulating layer 62 may be 3.6 or less, 3.5 or less, or 3.4 or less.

The Dk of the first insulating layer 61 may be smaller than the Dk of the second insulating layer 62.

Materials having the same dielectric loss factors Df or different dielectric loss factors Df may be applied as the first insulating layer 61 and the second insulating layer 62. Preferably, materials having a difference between the Df of the first insulating layer 61 and the Df of the second insulating layer 62 may be 0.0001 or more. The difference may be 0.0001 or more, 0.0005 or more, or 0.001 or more. The difference may be 0.02 or less.

The Df of the first insulating layer 61 may be 0.004 or less, 0.0038 or less, or 0.0036 or less. The Df of the first insulating layer 61 may be 0.001 or more, 0.0015 or more, 0.0018 or more, or 0.002 or more.

The Df of the second insulating layer 62 may be 0.005 or less, 0.0048 or less, or 0.0046 or less. The Df of the second insulating layer 62 may be 0.003 or more, 0.0032 or more, or 0.0034 or more.

The Df of the first insulating layer 61 may be smaller than the Df of the second insulating layer 62.

For example, an ABF may be applied to the second insulating layer 62 and an LCP may be applied to the first insulating layer 61. For example, an EMC may be applied to the second insulating layer 62 and an LCP may be applied to the first insulating layer 61. For example, ABFs having different dielectric constants may be applied to the second insulating layer 62 and the first insulating layer 61.

The first insulating layer 61 may be formed on a surface of the cavity element 40 using a method, for example, a varnish type method, a selective lamination method, a deposition method, or the like.

A conventional method of forming an insulating layer in a cavity of a packaging substrate may be applied to the second insulating layer 62, and a method applied to the formation of the first insulating layer 61 may also be applied to the second insulating layer 62.

Further, the present specification proposes a manufacturing method of generating the packaging substrate according to the embodiment disclosed in FIG. 6.

For example, a packaging substrate manufacturing method, comprising; preparing a glass substrate 21 in which a cavity portion 28 is disposed and a preprocessed cavity element 40; arranging the cavity element 40 in the cavity portion 28; laminating a second insulating layer 62 on the glass substrate, and forming a first insulating layer 61 on a surface other than one surface or all the surface of the cavity element 40, may be proposed. Further, for example, the first insulating layer 61 and the second insulating layer 62 may have different dielectric constants.

Specifically, the present specification proposes embodiments of generating the packaging substrate according to the following embodiment.

In one embodiment, a method of coating the first insulating layer on the cavity element before selecting and disposing the cavity element (a preparation of a cavity module) ; and then locating the cavity element coated with the first insulating layer in the cavity, and forming the second insulating layer through a re-distribution layer (RDL) process; may be proposed.

FIG. 7 is a flow chart for describing the packaging substrate manufacturing method according to the embodiment in cross-sections.

A process of forming the first insulating layer and the second insulating layer in the packaging substrate will be specifically viewed through FIG. 7 as follows.

For example, as shown in FIG. 7 (a), the first insulating layer 61 may be formed on some surfaces other than the upper surface or the bottom surface of the cavity element 40. For example, the first insulating layer 61 may be formed on some surfaces other than the upper surface or the bottom surface of the cavity element 40 by performing a sputtering process, coating process, or molding process on the cavity element 40.

That is, some surfaces other than the upper surface or the bottom surface of the cavity element 40 may be covered by the first insulating layer 61. For example, five surfaces other than the bottom surface of the cavity element 40 may be covered by the first insulating layer 61. Alternatively, for example, the edges of the upper surface of the cavity element 40 may be covered by the first insulating layer 61. That is, the first insulating layer 61 may be formed on the edges of the upper surface of the cavity element 40. In this case, for example, the one or more connection electrodes may be formed in the direction toward the bottom surface of the cavity element 40. Alternatively, for example, five surfaces other than the upper surface of the cavity element 40 may be covered by the first insulating layer 61. Alternatively, for example, the edges of the bottom surface of the cavity element 40 may be covered by the first insulating layer 61. That is, the first insulating layer 61 may be formed on the edges of the bottom surface of the cavity element 40. In this case, for example, one or more connection electrodes may be formed in the direction toward the upper surface of the cavity element 40.

The first insulating layer 61 may be formed on some surfaces other than the upper surface or the bottom surface of the cavity element 40 to prevent a short circuit due to contact between the cavity elements which are disposed side by side. Further, a short circuit, which may unintentionally occur during the manufacturing process of forming the electrically conductive layer on the side surface of the cavity portion 28, may be prevented using the first insulating layer 61 formed on some surfaces other than the upper surface or the bottom surface of the cavity element 40. Since a detailed description related to forming the first insulating layer on the cavity element overlaps that described above, a description thereof will be partially omitted.

The cavity element 40 may comprise passive elements and/or active elements. For example, a multilayer ceramic capacitor (MLCC) may be used as the cavity element 40. Alternatively, for example, an active element other than a passive element such as an MLCC may be used as the cavity element 40. Further, for example, the first insulating layer 61 may comprise the above-described liquid crystal polymer (LCP), epoxy molding compound (EMC), Ajinomoto Build-up Film (ABF), and/or Modified Polyimide (MPI) the like.

Hereinafter, as shown in FIG. 7 (b), the glass substrate 21 may be attached to an adhesive film such as a polyimide tape (PI tape), and the cavity element 40 on which the first insulating layer 61 is formed may be selected and disposed in the cavity portion 28 (designation of a position of the cavity element).

Next, as shown in FIG. 7 (c), a lamination process (lamination on top) in which the second insulating layer 62 is laminated on the first surface may be performed. The second insulating layer 62 may be laminated on the entire first surface of the glass substrate 21 and when curing (Pre-cure) is performed, as shown in FIG. 7 (d), the second insulating layer 62 may be incorporated into an inner space of the cavity portion 28. For example, the second insulating layer 62 may comprise an insulating mixture, and the insulating mixture may comprise inorganic particles and a polymer resin. For example, the second insulating layer 62 may comprise the above-described epoxy molding compound (EMC), Ajinomoto Build-up Film (ABF), and/or the like.

The adhesive film may be removed during a subsequent process as needed. For example, the adhesive film may be an adhesive film whose adhesive force may be reduced by irradiation with ultraviolet light or the like. The adhesive force of the adhesive film may be reduced by radiating ultraviolet rays to the adhesive film directly or through the glass core, or the like, and the adhesive film may be easily removed from the glass core. Further, the position of the cavity element may be fixed by the second insulating layer pre-cured by curing, and when the degree of warpage is controlled to a predetermined level or less, subsequent processes may be applied without fixing the adhesive film.

Next, as shown in FIG. 7 (e), a lamination process (lamination on bottom) in which the second insulating layer 62 is laminated on the second surface may be performed. The second insulating layer 62 may be laminated on the entire second surface of the glass substrate 21 and when curing (Pre-cure) is performed, as shown in FIG. 7 (f), the second insulating layer 62 may be incorporated into the inner space of the cavity portion 28.

Accordingly, according to FIG. 7, in one embodiment, a packaging substrate manufacturing method, comprising; generating a core via in a glass substrate 21 comprising first and second surfaces facing each other, generating a cavity portion 28 passing through the first and second surfaces of the glass substrate 21; forming a first insulating layer 61 on some surfaces other than one surface of the cavity element 40, arranging a cavity module a cavity element 40 on which the first insulating layer 61 is formed on one surface or all the surface in the cavity portion 28; and laminating the second insulating layer 62 on the first and second surfaces; may be proposed.

In one embodiment, a core via may be formed at a glass substrate 21 containing the first and second surfaces facing each other, a cavity 28 penetrating the first and second surfaces of the glass substrate 21, a first insulating layer 61 is formed on the entire surface or the entire surface except for one surface of the cavity 40. A method of manufacturing a packaging substrate may be proposed by arranging the cavity element 40 with the first insulating layer 61 formed on the entire surface or the entire surface except for the one surface; laminatingg the second insulating layer 62 on the first surface and the second surface.

In another embodiment, a method of selecting and disposing a cavity element in the cavity; and then forming a second insulating layer in a re-distribution layer (RDL) process after coating (or disposing) a first insulating layer on the cavity element, and etching the first insulating layer coated on a specific surface (for example, the upper surface or bottom surface) of the cavity element; may be proposed.

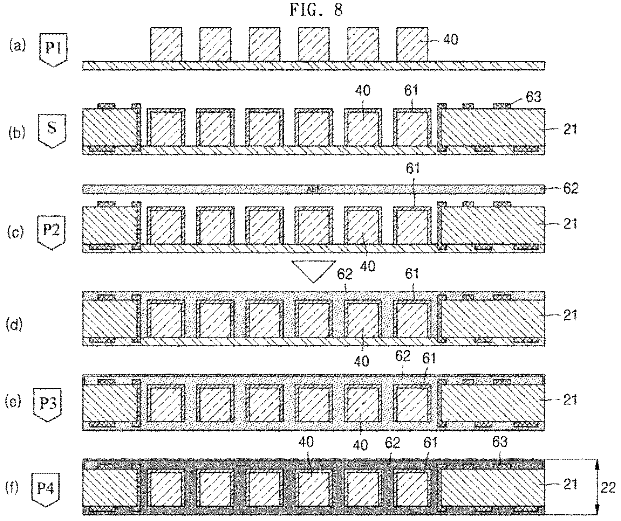

FIG. 8 is a flow chart for describing a packaging substrate manufacturing method according to another embodiment in cross-sections.

A process of forming the first insulating layer and the second insulating layer in the packaging substrate will be specifically viewed through FIG. 8 as follows.

For example, as shown in FIG. 8 (a), the cavity element 40 may be attached to an adhesive film such as a polyimide tape (PI tape). The cavity element 40 may comprise passive elements and/or active elements. For example, a multilayer ceramic capacitor (MLCC) may be used as the cavity element 40. Alternatively, for example, an active element other than the passive element such as an MLCC may be used as the cavity element 40.

Hereinafter, as shown in FIG. 8 (b), the first insulating layer 61 may be formed on some surfaces other than the upper surface or the bottom surface of the cavity element 40 disposed in the cavity portion 28. The cavity element 40 may be and disposed in the cavity portion 28 of the glass substrate 21 and then the above procedure may be performed. For example, the first insulating layer 61 may be formed on some surfaces other than the upper surface or the bottom surface of the cavity element 40 by performing a sputtering process, coating process, or molding process on the cavity element 40 in the cavity portion 28. Some surfaces other than the upper surface or the bottom surface of the cavity element 40 disposed in the cavity portion 28 may be covered by the first insulating layer 61. For example, five surfaces other than the bottom surface of the cavity element 40 may be covered by the first insulating layer 61. Alternatively, for example, the edges of the upper surface of the cavity element 40 may be covered by the first insulating layer 61. That is, the first insulating layer 61 may be formed on the edges of the upper surface of the cavity element 40. In this case, for example, one or more connection electrodes may be formed in the direction toward the bottom surface of the cavity element 40. Alternatively, for example, five surfaces other than the upper surface of the cavity element 40 may be covered by the first insulating layer 61. Alternatively, for example, the edges of the bottom surface of the cavity element 40 may be covered by the first insulating layer 61. That is, the first insulating layer 61 may be formed on the edges of the bottom surface of the cavity element 40. In this case, for example, one or more connection electrodes may be formed in the direction toward the upper surface of the cavity element 40.

Since the first insulating layer 61 may be formed on some surfaces other than the upper surface or the bottom surface of the cavity element 40, it is possible to prevent a short circuit due to contact between the cavity elements, which are disposed side by side. Further, a short circuit, which may unintentionally occur during the manufacturing process of forming the electrically conductive layer on the side surface of the cavity portion 28, may be prevented using the first insulating layer 61 formed on some surfaces other than the upper surface or the bottom surface of the cavity element 40.

The first insulating layer 61 may comprise the above-described liquid crystal polymer (LCP), epoxy molding compound (EMC), Ajinomoto Build-up Film (ABF) and/or Modified Polyimide (MPI) the like. Since a more detailed description of the cavity element and the first insulating layer overlaps with that described above, a detailed description thereof will be omitted.

Next, as shown in FIG. 8 (C), a lamination process (lamination on top) in which the second insulating layer 62 is laminated on the first surface may be performed (P2). The second insulating layer 62 may be laminated on the entire first surface of the glass substrate 21 and when curing (Pre-cure) is performed, as shown in FIG. 8 (d), the second insulating layer 62 may be incorporated into the inner space of the cavity portion 28. For example, the second insulating layer 62 may comprise an insulating mixture, and the insulating mixture may comprise inorganic particles and a polymer resin. For example, the second insulating layer 62 may comprise the above-described Ajinomoto Build-up Film (ABF). Since a detailed description of each insulating layer overlaps that described above, a detailed description thereof will be omitted.

The adhesive film may be removed during a subsequent process as needed. For example, the adhesive film may be an adhesive film whose adhesive force may be reduced by irradiation with ultraviolet light or the like. The adhesive force of the adhesive film may be reduced by radiating ultraviolet rays to the adhesive film directly or through the glass core, or the like, and the adhesive film may be easily removed from the glass core. Further, the position of the cavity element may be fixed by the second insulating layer pre-cured by curing, and when the degree of warpage is controlled to a predetermined level or less, subsequent processes may be applied without fixing the adhesive film.

Next, as shown in FIG. 8 (e), a lamination process (lamination on bottom) in which the second insulating layer 62 is laminated on the second surface may be performed (P3). The second insulating layer 62 may be laminated on the entire second surface of the glass substrate 21 and when curing (Pre-cure) is performed, as shown in FIG. 8 (f), the second insulating layer 62 may be incorporated into the inner space of the cavity portion 28.

Accordingly, according to FIG. 8, in one embodiment, a packaging substrate manufacturing method, comprising; generating a core via in a glass substrate 21 comprising first and second surfaces facing each other, generating a cavity portion 28 passing through the first and second surfaces of the glass substrate 21; arranging a cavity element 40 in the cavity portion 28, forming a first insulating layer 61 on some surfaces other than the bottom surface of the cavity element 40; and laminating a second insulating layer 62 on the first and second surfaces, may be proposed.

The methods of manufacturing a packaging substrate according to the above-described embodiments and a packaging substrate manufactured thereby may prevent an undulation phenomenon, which occurs due to a gap between elements and/or a gap between a cavity portion and an element, and may prevent a leakage current from occurring in the cavity portion.

A method of manufacturing a packaging substrate according to an embodiment and a packaging substrate manufactured thereby can improve the quality of a packaging substrate by preventing the occurrence of an undulation phenomenon of a cavity portion in which a cavity element is embedded.

Further, as the undulation phenomenon of the cavity portion is improved, a leakage current can be prevented from occurring in the cavity element comprising a passive element and/or an active element, and the quality of the packaging substrate can be significantly improved.

In addition, since a first insulating layer having a dielectric constant different from that of a second insulating layer is formed on some surfaces other than one surface or on all the surface of the cavity element, a short circuit due to contact between cavity elements disposed side by side can be prevented, and a short circuit, which may unintentionally occur during a manufacturing process of forming an electrically conductive layer on a side surface of the cavity portion, can be prevented.

The present specification described above has been described with reference to the embodiments shown in the drawings, but this is merely exemplary, and those skilled in the art will understand that various modifications and variations of the embodiments are possible. That is, the scope of the present specification is not limited to the above-described embodiments, and various modifications and improved forms by those skilled in the art using the basic concepts of the embodiments defined in the following claims also belong to the scope of the embodiments. Accordingly, the true technical scope of the present specification should be defined by the technical spirit of the appended claims.

## Claims

1. A packaging substrate comprising, a core layer comprising a glass substrate having a first surface and a second surface facing each other and a cavity portion passing through the glass substrate,
wherein a cavity module is disposed in the cavity portion,
the cavity module comprise a cavity element and a first insulating layer is disposed on some surfaces other than one surface or on all the surface of the cavity element, and a second insulating layer is incorporated into a remaining portion of the cavity portion other than the cavity module, and
the first insulating layer and the second insulating layer have different dielectric constants.

2. The packaging substrate of claim 1, wherein the first insulating layer has a dielectric constant lower than that of the second insulating layer.

3. The packaging substrate of claim 1 or claim 2, wherein a high-frequency dielectric constant Dk is the dielectric constant at a high frequency of 5.8 Ghz, and
a difference between Dk1 as a high-frequency dielectric constant of the first insulating layer and Dk2 as a high-frequency dielectric constant of the second insulating layer is 0.1 or more.

4. The packaging substrate of any one from claim 1 to claim 3, wherein the dielectric loss factor of the first insulating layer is Df1, the dielectric loss factor of the second insulating layer is Df2, and a difference between the Df1 and the Df2 is 0.0001 or more.

5. The packaging substrate of any one from claim 1 to claim 4, wherein the first insulating layer comprises liquid crystal polymer (LCP), Epoxy Molding Compound (EMC), Ajinomoto Build-up Film (ABF), or Modified Polyimide (MPI).

6. The packaging substrate of any one from claim 1 to claim 5, wherein:
the second insulating layer comprises an insulating mixture; and
the insulating mixture comprises inorganic particles and a polymer resin.

7. The packaging substrate of any one from claim 1 to claim 6, wherein one or more connection electrodes are disposed in a direction toward the bottom surface of the cavity element.

8. The packaging substrate of any one from claim 1 to claim 7, wherein the cavity element comprises a passive element or an active element.

9. The packaging substrate of any one from claim 1 to claim 8,
wherein a first insulating layer via penetrating the first insulating layer is further disposed at the first insulating layer, and parts of or all the first insulating layer via is filled with an electrode material.

10. A method of manufacturing a packaging substrate, comprising:
preparing a glass substrate in which a cavity portion is disposed and a cavity module;
arranging the cavity module in the cavity portion; and
laminating a second insulating layer on the glass substrate,
wherein the cavity module comprises a cavity element and a first insulating layer surrounding at least a part of the cavity element, and the first insulating layer is disposed on a surface other than one surface or on all the surface of the cavity element.

11. The method of claim 10, wherein the first insulating layer and the second insulating layer have different dielectric constants.

12. The method of claim 10 or claim 11, wherein the first insulating layer comprises liquid crystal polymer (LCP), Epoxy Molding Compound (EMC), Ajinomoto Build-up Film (ABF), or Modified Polyimide (MPI).

13. The method of any one from claim 10 to claim 12, wherein the second insulating layer comprises an Ajinomoto Build-up Film (ABF) or an epoxy molding compound (EMC).

14. The method of any one from claim 10 to claim 13, wherein one or more connection electrodes are formed in a direction toward the bottom surface of the cavity element.
